# EUROPEAN PATENT APPLICATION

(11) **EP 4 050 759 A1**
(43) Date of publication of application: **31.08.2022**
(21) Application number: 21195687.5
(22) Date of filing: 09.09.2021
(51) Int. Cl.: H02J 50/90

(54) **WIRELESS CHARGING METHOD, ELECTRONIC DEVICE AND MOBILE TERMINAL**

(30) Priority: 26.02.2021 CN 202110221183
(71) Applicant: Beijing Xiaomi Mobile Software Co., Ltd., Beijing 100085 (CN)
(72) Inventor: DU, Hui, Beijing, 100085 (CN); DING, Rui, Beijing, 100085 (CN); CHEN, Shan, Beijing, 100085 (CN)
(74) Representative: dompatent von Kreisler Selting Werner - Partnerschaft von Patent- und Rechtsanwälten mbB

(57) **Abstract**

The present disclosure relates to a wireless charging method, an electronic device and a mobile terminal. The wireless charging method includes: acquiring (S101) identification information of a charging device, wherein the identification information is configured to indicate a position state between the mobile terminal and the charging device; in response to determining that the identification information meets a preset charging condition, controlling (S102) an electromagnet body in the mobile terminal to be powered on to attract the charging device; and when the identification information does not meet the preset charging condition, controlling (S103) the electromagnet body in the mobile terminal to be powered off. The mobile terminal powers on the electromagnet body only when charging, to make it be in a magnetic state; and after the charging is completed, powers off it to make it be in a non-magnetic state. In this way, it can not only ensure the position stability and charging stability of the mobile terminal and the charging equipment when charging, but also avoid affecting the normal operation of other equipment in the environment, especially the normal operation of pacemakers, cochlear implants, hearing aids, and defibrillators in the human body, during normal use of the mobile terminal, thus the security of the mobile terminal can be improved.

## Description

### TECHNICAL FIELD

The present disclosure relates to the field of wireless charging technology, in particular to a wireless charging method, an electronic device and a mobile terminal.

### BACKGROUND

With the progress of science and technology, the functions of mobile terminals are becoming more and more abundant. For example, wireless magnetic charging technology not only realizes wireless charging, which makes charging more convenient and simple, but also realizes the magnetic attraction fixation of the mobile terminal and the charging equipment, which ensures that the positions of the two are fixed to improve the stability of charging. However, the magnets used for magnetic attraction in mobile terminals can easily affect the normal operation of other equipment in the environment, especially the normal operation of pacemakers, cochlear implants, hearing aids and defibrillators in the human body, which will cause danger.

### SUMMARY

In order to overcome the problems in the related art, the present disclosure provides a wireless charging method, an electronic device and a mobile terminal, to at least partially solve the defects in the related art.

According to a first aspect of the present disclosure, there is provided a wireless charging method, applied to a mobile terminal, and the method includes:
acquiring, by a mobile terminal, identification information of a charging device, wherein the identification information is configured to indicate a position state between the mobile terminal and the charging device;
in response to determining that the identification information meets a preset charging condition, controlling an electromagnet body in the mobile terminal to be powered on, such that the mobile terminal is attracted to the charging device; and
in response to determining that the identification information does not meet the preset charging condition, controlling the electromagnet body in the mobile terminal to be powered off.

Optionally, the identification information includes: a near field communication signal between the mobile terminal and the charging device; and

when the near field communication signal indicates that the mobile terminal and the charging device are successfully matched, the identification information meets the preset charging condition.

Optionally, the identification information includes: a charging current of the mobile terminal or the charging device; and
when the charging current is greater than or equal to a preset current threshold, the identification information meets the preset charging condition.

Optionally, the identification information includes: a distance between the mobile terminal and the charging device, wherein the distance is sensed by a Hall sensor in the mobile terminal and a Hall sensor in the charging device; and
when the distance is less than or equal to a preset distance threshold, the identification information meets the preset charging condition.

According to a second aspect of the present disclosure, there is provided a mobile terminal, including:
a processor; and
a memory for storing instructions executable by the processor,
wherein the processor is configured to:
acquire identification information of a charging device, wherein the identification information is configured to indicate a position state between the mobile terminal and the charging device;
determine whether the identification information meets a preset charging condition; and
power on or off an electromagnet body according to a determining result of the determining module.

According to a third aspect of the present disclosure, there is provided a mobile terminal, including:
a first electromagnet body, configured to match a second magnet body in a charging device, such that the mobile terminal is attracted to the charging device;
a first wireless charging coil, configured to match a second wireless charging coil in the charging device, such that electric energy is transmitted between the mobile terminal and the charging device; and
a controller, configured to be electrically connected to the first electromagnet body, to control the first electromagnet body to be powered on or off.

Optionally, the mobile terminal is provided with a plurality of first electromagnet bodies, and the plurality of first electromagnet bodies are disposed around the first wireless charging coil.

Optionally, the mobile terminal is further provided with a first near field communication antenna being electrically connected to the controller, and the first near field communication antenna is configured to match a second near field communication antenna of the charging device, to determine a near field communication signal between the mobile terminal and the charging device.

Optionally, the first near field communication antenna is disposed around the first wireless charging coil.

Optionally, the mobile terminal is further provided with a first Hall sensor being electrically connected to the controller, and the first Hall sensor is configured to match a second Hall sensor of the charging device, to determine a distance between the mobile terminal and the charging device.

Optionally, the first Hall sensor is disposed around the first wireless charging coil.

Optionally, the mobile terminal has a back cover, wherein both the first electromagnet body and the first wireless charging coil are provided on an inner surface of the back cover

The technical solutions provided by the present disclosure include the following beneficial effects:

In the present disclosure, by obtaining the identification information that indicates the position state between the mobile terminal and the charging device, and determining whether the identification information meets the preset charging condition, when the charging condition is met, the electromagnet body in the mobile terminal can be controlled to be powered on to attract the charging device, and when the charging condition is not met, the electromagnet body in the mobile terminal can be controlled to be powered off. In other words, the mobile terminal only powers on the electromagnet body when charging to be in a magnetic state, and then powers it off after the end of charging to be in a non-magnetic state. In this way, it can not only ensure the position stability and charging stability of the mobile terminal and the charging equipment when charging, but also avoid affecting the normal operation of other equipment in the environment, especially the normal operation of pacemakers, cochlear implants, hearing aids, and defibrillators in the human body, during normal use of the mobile terminal, thus the security of the mobile terminal can be improved.

### BRIEF DESCRIPTION OF THE DRAWINGS

The accompanying drawings here are incorporated into the specification and constitute a part of the specification, show examples in accordance with the present disclosure, and together with the specification are used to explain the principle of the present disclosure.
FIG. 1 is a schematic flowchart of a wireless charging method shown in an exemplary embodiment of the present disclosure;
FIG. 2 is a schematic structural diagram of an electronic device shown in an exemplary embodiment of the present disclosure;
FIG. 3 is a schematic diagram of the internal structure of a mobile terminal according to an exemplary embodiment of the present disclosure;
FIG. 4 is a schematic diagram of the internal structure of a mobile terminal according to another exemplary embodiment of the present disclosure; and
FIG. 5 is a schematic diagram of the internal structure of a mobile terminal according to further another exemplary embodiment of the present disclosure.

### DETAILED DESCRIPTION

The exemplary embodiments will be described in detail here, and examples thereof are shown in the accompanying drawings. When the following description refers to the drawings, unless otherwise indicated, the same numbers in different drawings indicate the same or similar elements. The implementation manners described in the following exemplary embodiments do not represent all implementation manners consistent with the present disclosure. Rather, they are only examples of devices and methods consistent with some aspects of the present disclosure as detailed in the appended claims.

The terms used in the present disclosure are only for the purpose of describing specific examples, and are not intended to limit the present disclosure. The singular forms of "a", "said" and "the" used in the present disclosure and appended claims are intended to include plural forms as well, unless the context clearly indicates other meanings. It should be understood that the term "and/or" as used herein refers to and includes any or all possible combinations of one or more associated listed items as well.

Reference throughout this specification to "one embodiment," "an embodiment," "an example," "some embodiments," "some examples," or similar language means that a particular feature, structure, or characteristic described is included in at least one embodiment or example. Features, structures, elements, or characteristics described in connection with one or some embodiments are also applicable to other embodiments, unless expressly specified otherwise.

It should be understood that although the terms first, second, third, etc. may be used in this disclosure to describe various information, the information should not be limited to these terms. These terms are only used to distinguish the same type of information from each other. For example, without departing from the scope of the present disclosure, the first information may be referred to as second information as well, and similarly, the second information may be referred to as first information as well. Depending on the context, the word "if' as used herein can be interpreted as "when" or "while" or "in response to determine".

The terms "module," "sub-module," "circuit," "sub-circuit," "circuitry," "subcircuitry," "unit," or "sub-unit" may include memory (shared, dedicated, or group) that stores code or instructions that can be executed by one or more processors. A module may include one or more circuits with or without stored code or instructions. The module or circuit may include one or more components that are directly or indirectly connected. These components may or may not be physically attached to, or located adjacent to, one another.

A unit or module may be implemented purely by software, purely by hardware, or by a combination of hardware and software. In a pure software implementation, for example, the unit or module may include functionally related code blocks or software components, that are directly or indirectly linked together, so as to perform a particular function.

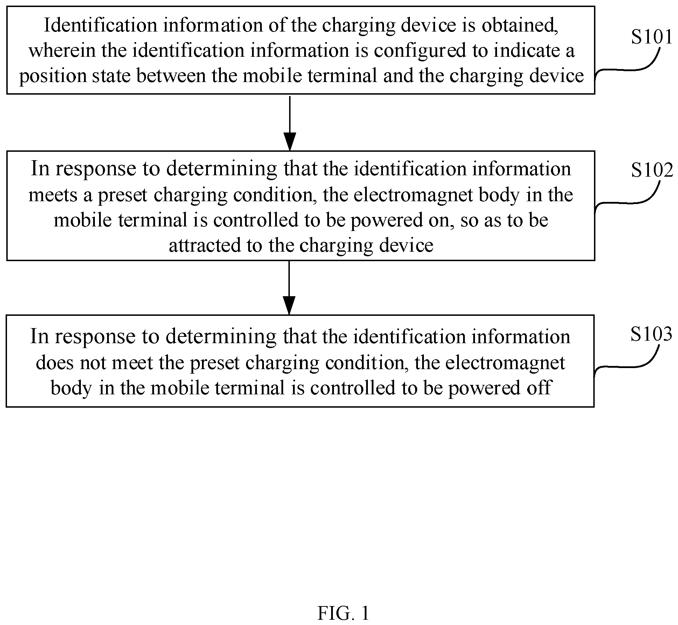

According to a first aspect, at least one example of the present disclosure provides a wireless charging method. Please refer to FIG. 1, which shows the flow of the method, including step S101 to step S103.

The method is applied to a mobile terminal. An electromagnet body is provided in the mobile terminal. By powering on and off the electromagnet body, the electromagnet body can be in different states, that is, a magnetic state after power on, and a non-magnetic state after power off.

In step S101, identification information of the charging device is obtained, wherein the identification information is configured to indicate a position state between the mobile terminal and the charging device.

The position state between the mobile terminal and the charging device may include a combining state and a separating state, wherein the combining state refers to a charging state of the mobile terminal and the charging device (such as a wireless charging base); and the separating state refers to a non-charging state of the mobile terminal and the charging device.

In step S102, in response to determining that the identification information meets a preset charging condition, the electromagnet body in the mobile terminal is controlled to be powered on, so as to be attracted to the charging device.

When the mobile terminal and the electronic device are in a combining state, it can be determined that the identification information meets the preset charging condition.

In step S103, in response to determining that the identification information does not meet the preset charging condition, the electromagnet body in the mobile terminal is controlled to be powered off.

In the examples of the present disclosure, by acquiring identification information that indicates the position state between the mobile terminal and the charging device, and determining whether the identification information meets the preset charging condition, it is possible to control the electromagnet body in the mobile terminal to be powered on when the charging condition is met, so as to be attracted with the charging device, and when the charging condition is not met, the electromagnet body in the mobile terminal is controlled to be powered off. In other words, the mobile terminal powers on the electromagnet body to make it be in the magnetic state only when charging, and then powers off the electromagnet body after the end of charging, to make it be in the non-magnetic state. In this way, it can not only ensure the position stability and charging stability of the mobile terminal and the charging equipment when charging, but also avoid affecting the normal operation of other equipment in the environment, especially the normal operation of pacemakers, cochlear implants, hearing aids, and defibrillators in the human body, during normal use of the mobile terminal, thus the security of the mobile terminal can be improved.

In some examples of the present disclosure, a charging current of the mobile terminal and the charging device can be configured as the identification information. When the mobile terminal and the charging device enter the combining state (for example, the mobile terminal is placed on the wireless charging base), the mobile terminal and the charging device enter the charging state, and electromagnetic energy transmission starts between the two, wherein the electromagnetic energy corresponds to a certain charging current. Specifically, the mobile terminal has a first wireless charging coil, and the charging device has a second wireless charging coil. The electromagnetic energy transmission is performed between the first wireless charging coil and the second wireless charging coil during charging, for example, electromagnetic energy flows from the second wireless charging coil to the first wireless charging coil wherein the electromagnetic energy corresponds to the charging current flowing in the first wireless charging coil or the second wireless charging coil. After entering the combining state or charging state, the mobile terminal and the charging device need to be attracted and fixed to each other, so a current threshold of the charging current can be preset. When the charging current is greater than or equal to the preset current threshold, it is determined that the identification information meets the preset charging condition.

In some examples of the present disclosure, in order to detect the identification information configured to indicate the position state between the mobile terminal and the charging device, corresponding sensing elements may be further provided in the mobile terminal and the charging device. For example, the sensing element may be near field communication (NFC).) antenna and/or Hall sensor.

Based on the above, a near field communication signal between the mobile terminal and the charging device can be configured as identification information. When the mobile terminal and the charging device enter the combining state, the near field communication antenna in the mobile terminal and the near field communication antenna in the charging device enter into a range for mutual recognition. Since a matching condition between the near field communication antennas is preset in advance, the near field communication signal indicates that the mobile terminal and the charging device are successfully matched. Therefore, when the near field communication signal indicates that the mobile terminal and the charging device are successfully matched, it is determined that the identification information meets the preset charging condition.

Based on the above, a distance between the mobile terminal and the charging device sensed by the Hall sensor in the mobile terminal and the Hall sensor in the charging device can be configured as the identification information. When the mobile terminal and the charging device enter the combining state, the distance between the two is small. A distance threshold can be preset, and when the distance is less than the preset distance threshold, it is determined that the identification information meets the preset charging condition.

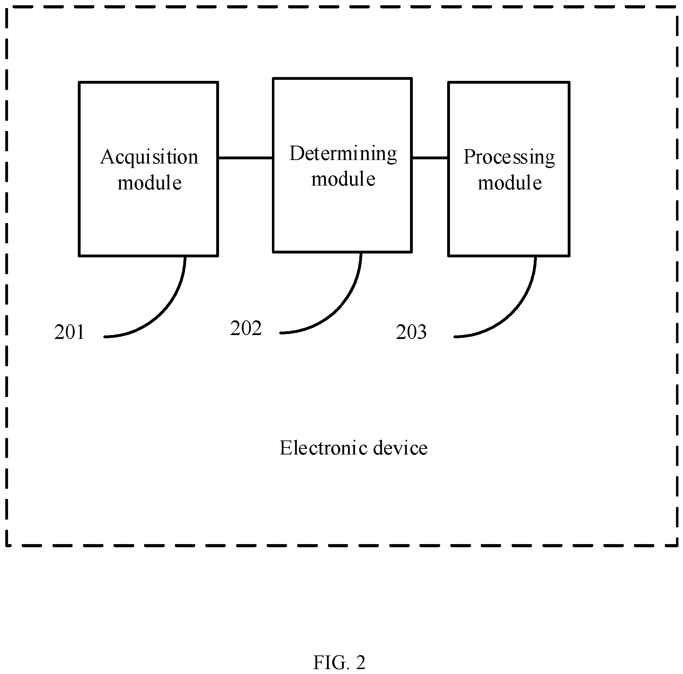

According to a second aspect, at least one example of the present disclosure provides an electronic device. Please refer to FIG. 2, which shows a schematic structural diagram of the electronic device. The electronic device includes: an acquisition module 201 configured to acquire the identification information of the charging device, wherein the identification information is configured to indicate the position state between the mobile terminal and the charging equipment; a determining module 202 configured to determine whether the identification information meets the preset charging condition; and a processing module 203 configured to power on or off the electromagnet body according to a determining result of the determining module.

It shall be noticed that the electronic device provided in the above-mentioned embodiment is illustrated only by the division of the respective function modules described above when realizing their functions. In practical application, the above-mentioned functions may be assigned to be accomplished by different function modules according to the actual needs, that is, the content structures of the apparatuses are divided into different function modules in order to accomplish all or part of the above-described functions.

It can be understood that in order to implement the above-mentioned functions, the electronic device includes corresponding hardware structures and/or software modules that execute the respective functions. The examples of the present disclosure can be implemented in the form of hardware or a combination of hardware and computer software by reference to units and algorithmic steps of the examples described in the present disclosure. Whether a particular function is performed by hardware or by computer software driving hardware depends on the particular application and design constraints of the technical solution. A person skilled in the art may use a different method for implementing the described function for each particular application, but such an implementation shall not be considered as going outside the scope of the examples of the present disclosure.

Correspondingly, at least one example of the present disclosure provides an electronic device, applied for a mobile terminal, comprising:
a processor; and
a memory for storing instructions executable by the processor,
wherein the processor is configured to:
acquire identification information of a charging device, wherein the identification information is configured to indicate a position state between a mobile terminal and the charging device;
determine whether the identification information meets a preset charging condition; and
power on or off an electromagnet body according to a determining result of the determining module.

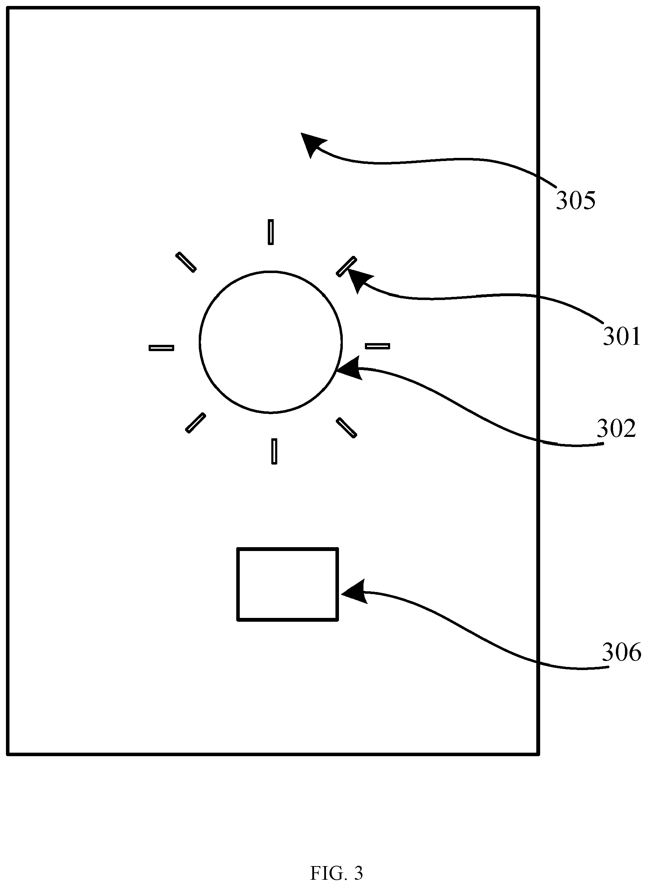

According to a third aspect, at least one example of the present disclosure provides a mobile terminal. Please refer to FIG. 3 to FIG. 5, which show the positional relationship of the components in the mobile terminal, the mobile terminal includes: a first electromagnet body 301, configured to match a second magnet body in the charging device, to allow the mobile terminal to be attracted to the charging device; a first wireless charging coil 302, configured to match the second wireless charging coil in the charging device, to make the mobile terminal and the charging device transmit electric energy therebetween; and a controller 306, configured to be connected to the first electromagnet body 301, to control the power on or off of the first electromagnet body 301.

The first electromagnet body 301 has a magnetic state and a non-magnetic state, that is, it enters the magnetic state when it is powered on, or the non-magnetic state when it is powered off. When the mobile terminal has a plurality of first electromagnet bodies 301, the states of all the first electromagnet bodies 301 can be controlled uniformly, that is, all the first electromagnet bodies 301 can enter the magnetic state at the same time, or the non-magnetic state at the same time, such that the magnetic fields of these first electromagnet bodies 301 can be superimposed when they are in the magnetic state to achieve a stronger magnetic field. The first electromagnet body 301 may include a metal cylinder and a metal coil wound on the metal cylinder. The metal coil is electrically connected to the controller, and the controller can control the metal coil to be powered on or powered off, so as to make the first electromagnet body enter the magnetic state or a non-magnetic state.

When the mobile terminal has a plurality of first electromagnet bodies 301, the plurality of first electromagnet bodies 301 may be disposed in an array of ring shape, that is, the plurality of first electromagnet bodies 301 are evenly distributed on a ring, and each first electromagnet body 301 is disposed along the radial direction of the ring.

The controller 306 can be a dedicated controller configured to control wireless charging, such as a microcontroller (MCU), and the controller can be the main controller of the mobile terminal as well, that is, the main controller has a dedicated module configured to control the realization of the above wireless charging method.

Wherein, the second magnet body may be an electromagnet body or a permanent magnet body.

Referring to FIG. 3, the mobile terminal is provided with a plurality of first electromagnet bodies 301, and the plurality of first electromagnet bodies 301 are disposed around the first wireless charging coil 302. The first wireless charging coil 302 is disposed in the middle of the plurality of first electromagnet bodies 301, such that the first wireless charging coil 302 and the second wireless charging coil are directly facing each other after magnetic attraction, so as to improve the efficiency and power of wireless charging.

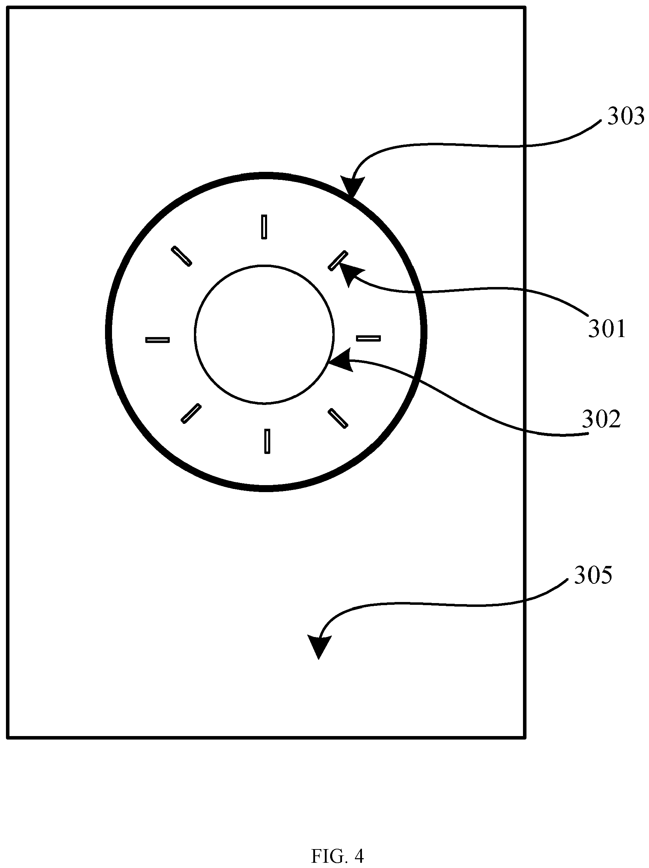

Referring to FIG. 4, the mobile terminal is further provided with a first near field communication antenna 303 being electrically connected to the controller, and the first near field communication antenna 303 is configured to match the second near field communication antenna of the charging device, to determine the near field communication signal between the mobile terminal and the charging device. The first near field communication antenna 303 is disposed around the first wireless charging coil 302.

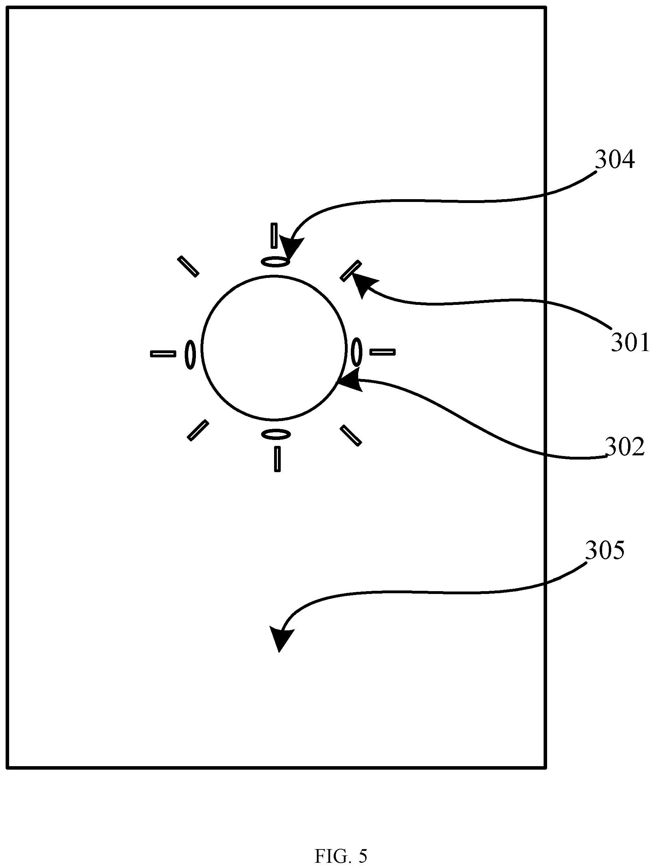

Referring to FIG. 5, the mobile terminal is further provided with a first hall sensor 304 being electrically connected to the controller, and the first hall sensor 304 is configured to match the second hall sensor of the charging device, to determine the distance between the mobile terminal and the charging device. A plurality of first Hall sensors 304 may be disposed, and disposed around the first wireless charging coil 302.

Optionally, the mobile terminal has a back cover 305, wherein the first electromagnet body 301 and the first wireless charging coil 302 are both provided on an inner surface of the back cover 305. Similarly, the first near field communication antenna 303 and the first Hall sensor 304 can be provided on the inner surface of the back cover 305 as well.

In an example, the identification information includes: a near field communication signal between the mobile terminal and the charging device; and
when the near field communication signal indicates that the mobile terminal and the charging device are successfully matched, the identification information meets the preset charging condition.

In an example, the identification information includes: a charging current of the mobile terminal or the charging device; and
when the charging current is greater than or equal to a preset current threshold, the identification information meets the preset charging condition.

In an example, the identification information includes: a distance between the mobile terminal and the charging device, wherein the distance is sensed by a Hall sensor in the mobile terminal and a Hall sensor in the charging device; and
when the distance is less than or equal to a preset distance threshold, the identification information meets the preset charging condition.

In an example, the mobile terminal is provided with a plurality of first electromagnet bodies, and the plurality of first electromagnet bodies are arranged around the first wireless charging coil.

In an example, the mobile terminal is further provided with a first near field communication antenna being electrically connected to the controller, and the first near field communication antenna is configured to match a second near field communication antenna of the charging device, to determine a near field communication signal between the mobile terminal and the charging device.

In an example, the first near field communication antenna is arranged around the first wireless charging coil.

In an example, the mobile terminal is further provided with a first Hall sensor being electrically connected to the controller, and the first Hall sensor is configured to match a second Hall sensor of the charging device, to determine a distance between the mobile terminal and the charging device.

In an example, the first Hall sensor is arranged around the first wireless charging coil.

In an example, the mobile terminal has a back cover, wherein both the first electromagnet body and the first wireless charging coil are provided on an inner surface of the back cover

The technical solutions provided by the examples of the present disclosure may include the following beneficial effects:

In the present disclosure, by obtaining the identification information that indicates the position state between the mobile terminal and the charging device, and determining whether the identification information meets the preset charging condition, when the charging condition is met, the electromagnet body in the mobile terminal can be controlled to be powered on to attract the charging device, and when the charging condition is not met, the electromagnet body in the mobile terminal can be controlled to be powered off. In other words, the mobile terminal only powers on the electromagnet body when charging to make it be in a magnetic state, and then powers off it after the end of charging to make it be in a non-magnetic state. In this way, it can not only ensure the position stability and charging stability of the mobile terminal and the charging equipment when charging, but also avoid affecting the normal operation of other equipment in the environment, especially the normal operation of pacemakers, cochlear implants, hearing aids, and defibrillators in the human body, during normal use of the mobile terminal, thus the security of the mobile terminal can be improved

Those skilled in the art will easily think of other examples of the present disclosure after considering the specification and practicing the disclosure disclosed herein. This application is intended to cover any variations, uses, or adaptive changes of the present disclosure. These variations, uses, or adaptive changes follow the general principles of the present disclosure and include common knowledge or conventional technical means in the technical field that are not disclosed in the present disclosure. The description and the examples are to be regarded as exemplary only, and the true scope and spirit of the present disclosure are pointed out by the following claims.

It should be understood that the present disclosure is not limited to the precise structure that has been described above and shown in the drawings, and various modifications and changes can be made without departing from its scope. The scope of the present disclosure is only limited by the appended claims.

## Claims

1. A wireless charging method, applied for a mobile terminal, comprising:
acquiring (S101) identification information of a charging device, wherein the identification information is configured to indicate a position state between the mobile terminal and the charging device;
in response to determining that the identification information meets a preset charging condition, controlling (S102) an electromagnet body in the mobile terminal to be powered on, such that the mobile terminal is attracted to the charging device; and
in response to determining that the identification information does not meet the preset charging condition, controlling (SI03) the electromagnet body in the mobile terminal to be powered off.

2. The method according to claim 1, wherein the identification information comprises: a near field communication signal between the mobile terminal and the charging device; and
when the near field communication signal indicates that the mobile terminal and the charging device are matched, the identification information meets the preset charging condition.

3. The method according to claim 1 or 2, wherein the identification information comprises:
a charging current of the mobile terminal or the charging device; and
when the charging current is greater than or equal to a preset current threshold, the identification information meets the preset charging condition.

4. The method according to any one of claims 1 to 3, wherein the identification information comprises: a distance between the mobile terminal and the charging device, wherein the distance is sensed by a Hall sensor in the mobile terminal and a Hall sensor in the charging device; and
when the distance is less than or equal to a preset distance threshold, the identification information meets the preset charging condition.

5. A mobile terminal, comprising:
a first electromagnet body (301), configured to match a second magnet body in a charging device, such that the mobile terminal is attracted to the charging device;
a first wireless charging coil (302), configured to match a second wireless charging coil in the charging device, such that electric energy is transmitted between the mobile terminal and the charging device; and
a controller (306), configured to be electrically connected to the first electromagnet body (301), to control the first electromagnet body (301) to be powered on or off.

6. The mobile terminal according to claim 5, further comprising:
a plurality of first electromagnet bodies (301), wherein the plurality of first electromagnet bodies (301) are disposed around the first wireless charging coil (302).

7. The mobile terminal according to claim 5 or 6, further comprising:
a first near field communication antenna (303) being electrically connected to the controller (306), wherein the first near field communication antenna (303) is configured to match a second near field communication antenna of the charging device, to determine a near field communication signal between the mobile terminal and the charging device.

8. The mobile terminal according to claim 7, wherein the first near field communication antenna (303) is disposed around the first wireless charging coil (302).

9. The mobile terminal according to any one of claims 5 to 8, further comprising:
a first Hall sensor (304) being electrically connected to the controller (306), wherein the first Hall sensor (304) is configured to match a second Hall sensor of the charging device, to determine a distance between the mobile terminal and the charging device.

10. The mobile terminal of claim 9, wherein the first Hall sensor (304) is disposed around the first wireless charging coil (302).

11. The mobile terminal according to any one of claims 5 to 10, further comprising:
a back cover (305), wherein both the first electromagnet body (301) and the first wireless charging coil (302) are provided on an inner surface of the back cover (305).
